# EUROPÄISCHE PATENTSCHRIFT

(11) **EP 3 937 600 B1**
(45) Veröffentlichungstag und Bekanntmachung des Hinweises auf die Patenterteilung: **21.02.2024**
(21) Anmeldenummer: 20185136.7
(22) Anmeldetag: 10.07.2020
(51) Int. Cl.: H05K 7/14

(54) **STROMRICHTERANORDNUNG MIT EINEM STROMRICHTERMODUL UND MIT EINER AUFNAHMEEINRICHTUNG**
POWER CONVERTER ASSEMBLY WITH A POWER CONVERTER MODULE AND A RECEIVING DEVICE
AGENCEMENT DE CONVERTISSEUR DE COURANT DOTÉ D'UN MODULE DE CONVERTISSEUR DE COURANT ET D'UN DISPOSITIF DE RÉCEPTION

(43) Veröffentlichungstag der Anmeldung: 12.01.2022
(73) Patentinhaber: SEMIKRON Elektronik GmbH & Co. KG, 90431 Nürnberg (DE)
(72) Erfinder: Sillard, Léo, 75017 Paris (FR); Vanhyfte, Francois, 95360 Montmagny (FR)

(56) Entgegenhaltungen:
- DE-A1- 19 711 016
- KR-B1- 101 468 143

## Beschreibung

Die Erfindung betrifft eine Stromrichteranordnung mit einem ein elektrisch leitendes Modulnegativpotentialelement und ein elektrisch leitendes Modulpositivpotentialelement aufweisenden Stromrichtermodul und mit einer ein elektrisch leitendes Aufnahmenegativpotentialelement und ein elektrisch leitendes Aufnahmepositivpotentialelement aufweisenden Aufnahmeeinrichtung zur Aufnahme des Stromrichtermoduls.

Aus der DE 10 2009 051 518 B3 ist eine Stromrichteranordnung mit einem ein elektrisch leitendes Modulnegativpotentialelement und ein elektrisch leitendes Modulpositivpotentialelement aufweisenden Stromrichtermodul und mit einer ein elektrisch leitendes Aufnahmenegativpotentialelement und ein elektrisch leitendes Aufnahmepositivpotentialelement aufweisenden Aufnahmeeinrichtung zur Aufnahme des Stromrichtermoduls, bei der das Modulnegativpotentialelement mit dem Aufnahmenegativpotentialelement und das Modulpositivpotentialelement mit dem Aufnahmepositivpotentialelement mittels einer Schraubverbindung elektrisch leitend verbunden sind. Die Schraubverbindung weist den Nachteil auf, dass das elektrische Verbinden des Stromrichtermoduls mit der Aufnahmeeinrichtung und, z.B. im Falle eines notwenigen Austauschs des Stromrichtermoduls, das elektrische Trennen des Stromrichtermoduls von der Aufnahmeeinrichtung zeitaufwendig ist.

Eine Umrichteranordnung mit modularem Aufbau ist in DE 197 11 016 A1 offenbart. In der Umrichteranordnung sind in ein Trägermodul und mindestens ein herausziehbares Modul offenbar, wobei das herausziehbare Modul stromsteuernde Bauelemente und insbesondere Leistungshalbleiter umfasst.

In KR 101 468 143 B1 ist eine Umrichterverbindungsvorrichtung mit abkoppelbaren Umrichtermodulen offenbart, wobei die Umrichtermodule bzw. die Umrichterverbindungsvorrichtung mittels Steckverbindungen mit der Umrichterverbindungsvorrichtung verbindbar sind.

Es ist Aufgabe der Erfindung eine Stromrichteranordnung mit einem Stromrichtermodul und mit einer Aufnahmeeinrichtung zu schaffen, bei der das Stromrichtermodul mit der Aufnahmeeinrichtung schnell und besonders zuverlässig elektrisch leitend verbunden und wieder elektrisch getrennt werden kann.

Diese Aufgabe wird gelöst durch eine Stromrichteranordnung mit einem ein elektrisch leitendes Modulnegativpotentialelement und ein elektrisch leitendes Modulpositivpotentialelement aufweisenden Stromrichtermodul, mit einer ein elektrisch leitendes Aufnahmenegativpotentialelement und ein elektrisch leitendes Aufnahmepositivpotentialelement aufweisenden Aufnahmeeinrichtung zur Aufnahme des Stromrichtermoduls, wobei das Modulnegativpotentialelement mit dem Aufnahmenegativpotentialelement und das Modulpositivpotentialelement mit dem Aufnahmepositivpotentialelement über eine Gleichspannungsteckverbindungseinrichtung elektrisch leitend verbunden sind, wobei die Gleichspannungsteckverbindungseinrichtung ein elektrisch leitendes erstes Steckverbindungselement, ein vom ersten Steckverbindungselement elektrisch isoliert angeordnetes elektrisch leitendes zweites Steckverbindungselement, ein elektrisch leitendes drittes Steckverbindungselement und ein vom dritten Steckverbindungselement elektrisch isoliertes angeordnetes elektrisch leitendes viertes Steckverbindungselement aufweist, wobei das erste Steckverbindungselement mit dem Modulnegativpotentialelement, das zweite Steckverbindungselement mit dem Modulpositivpotentialelement, das dritte Steckverbindungselement mit dem Aufnahmenegativpotentialelement und das vierte Steckverbindungselement mit dem Aufnahmepositivpotentialelement elektrisch leitend kontaktiert ist, wobei das erste Steckverbindungselement einen ersten Steckverbindungsabschnitt und das zweite Steckverbindungselement einen vom ersten Steckverbindungsabschnitt beabstandet angeordneten zweiten Steckverbindungsabschnitt aufweist, wobei zwischen dem ersten und zweiten Steckverbindungsabschnitt ein Steckverbindungsraum ausgebildet ist, wobei das dritte Steckverbindungselement einen dritten Steckverbindungsabschnitt und das vierte Steckverbindungselement einen vierten Steckverbindungsabschnitt aufweist, wobei der dritte und vierte Steckverbindungsabschnitt im Steckverbindungsraum angeordnet sind, wobei die Gleichspannungsteckverbindungseinrichtung eine mit dem ersten Steckverbindungsabschnitt einen elektrisch leitenden Kontakt aufweisende elektrisch leitende erste Federkontakteinrichtung aufweist, die mindestens ein erstes Federelement aufweist, das gegen den dritten Steckverbindungsabschnitt drückt und hierdurch einen elektrisch leitenden Druckkontakt mit dem dritten Steckverbindungsabschnitt ausbildet, wobei die Gleichspannungsteckverbindungseinrichtung eine mit dem zweiten Steckverbindungsabschnitt einen elektrisch leitenden Kontakt aufweisende elektrisch leitende zweite Federkontakteinrichtung aufweist, die mindestens ein zweites Federelement aufweist, das gegen den vierten Steckverbindungsabschnitt drückt und hierdurch einen elektrisch leitenden Druckkontakt mit dem vierten Steckverbindungsabschnitt ausbildet wobei die Gleichspannungsteckverbindungseinrichtung eine erste Klemmeinrichtung aufweist, die die erste Federkontakteinrichtung gegen den ersten Steckverbindungsabschnitt drückt, so dass sich ein elektrisch leitender Druckkontakt der ersten Federkontakteinrichtung mit dem ersten Steckverbindungsabschnitt ausbildet und wobei die Gleichspannungsteckverbindungseinrichtung eine zweite Klemmeinrichtung aufweist, die die zweite Federkontakteinrichtung gegen den zweiten Steckverbindungsabschnitt drückt, so dass sich ein elektrisch leitender Druckkontakt der zweiten Federkontakteinrichtung mit dem zweiten Steckverbindungsabschnitt ausbildet. Bei dieser Ausbildung der Gleichspannungsteckverbindungseinrichtung bildet das erste Steckverbindungselement zusammen mit dem zweiten Steckverbindungselement eine Buchse der Gleichspannungsteckverbindungseinrichtung aus und das dritte Steckverbindungselement bildet zusammen mit dem vierten Steckverbindungselement einen Stecker der Gleichspannungsteckverbindungseinrichtung aus. Durch die Klemmeinrichtungen wird das Stromrichtermodul darüber hinaus mit der Aufnahmeeinrichtung besonders zuverlässig elektrisch leitend verbunden.

In diesem Zusammenhang erweist es sich als vorteilhaft, wenn das erste Steckverbindungselement mit dem Modulnegativpotentialelement und das zweite Steckverbindungselement mit dem Modulpositivpotentialelement einstückig ausgebildet ist, und/oder dass das dritte Steckverbindungselement mit dem Aufnahmenegativpotentialelement und das vierte Steckverbindungselement mit dem Aufnahmepositivpotentialelement einstückig ausgebildet ist. Hierdurch ist die Gleichspannungsteckverbindungseinrichtung besonders zuverlässig ausgebildet.

Alternativ wird die Aufgabe gelöst durch eine Stromrichteranordnung mit einem ein elektrisch leitendes Modulnegativpotentialelement und ein elektrisch leitendes Modulpositivpotentialelement aufweisenden Stromrichtermodul, mit einer ein elektrisch leitendes Aufnahmenegativpotentialelement und ein elektrisch leitendes Aufnahmepositivpotentialelement aufweisenden Aufnahmeeinrichtung zur Aufnahme des Stromrichtermoduls, wobei das Modulnegativpotentialelement mit dem Aufnahmenegativpotentialelement und das Modulpositivpotentialelement mit dem Aufnahmepositivpotentialelement über eine Gleichspannungsteckverbindungseinrichtung elektrisch leitend verbunden sind, wobei die Gleichspannungsteckverbindungseinrichtung ein elektrisch leitendes erstes Steckverbindungselement, ein vom ersten Steckverbindungselement elektrisch isoliert angeordnetes elektrisch leitendes zweites Steckverbindungselement, ein elektrisch leitendes drittes Steckverbindungselement und ein vom dritten Steckverbindungselement elektrisch isoliertes angeordnetes elektrisch leitendes viertes Steckverbindungselement aufweist, wobei das erste Steckverbindungselement mit dem Aufnahmenegativpotentialelement, das zweite Steckverbindungselement mit dem Aufnahmepositivpotentialelement, das dritte Steckverbindungselement mit dem Modulnegativpotentialelement und das vierte Steckverbindungselement mit dem Modulpositivpotentialelement elektrisch leitend kontaktiert ist, wobei das erste Steckverbindungselement einen ersten Steckverbindungsabschnitt und das zweite Steckverbindungselement einen vom ersten Steckverbindungsabschnitt 6a` beabstandet angeordneten zweiten Steckverbindungsabschnitt aufweist, wobei zwischen dem ersten und zweiten Steckverbindungsabschnitt ein Steckverbindungsraum ausgebildet ist, wobei das dritte Steckverbindungselement einen dritten Steckverbindungsabschnitt und das vierte Steckverbindungselement einen vierten Steckverbindungsabschnitt aufweist, wobei der dritte und vierte Steckverbindungsabschnitt im Steckverbindungsraum angeordnet sind, wobei die Gleichspannungsteckverbindungseinrichtung eine mit dem ersten Steckverbindungsabschnitt einen elektrisch leitenden Kontakt aufweisende elektrisch leitende erste Federkontakteinrichtung aufweist, die mindestens ein erstes Federelement aufweist, das gegen den dritten Steckverbindungsabschnitt drückt und hierdurch einen elektrisch leitenden Druckkontakt mit dem dritten Steckverbindungsabschnitt ausbildet, wobei die Gleichspannungsteckverbindungseinrichtung eine mit dem zweiten Steckverbindungsabschnitt einen elektrisch leitenden Kontakt aufweisende elektrisch leitende zweite Federkontakteinrichtung aufweist, die mindestens ein zweites Federelement aufweist, das gegen den vierten Steckverbindungsabschnitt drückt und hierdurch einen elektrisch leitenden Druckkontakt mit dem vierten Steckverbindungsabschnitt ausbildet, wobei die Gleichspannungsteckverbindungseinrichtung eine erste Klemmeinrichtung aufweist, die die erste Federkontakteinrichtung gegen den ersten Steckverbindungsabschnitt drückt, so dass sich ein elektrisch leitender Druckkontakt der ersten Federkontakteinrichtung mit dem ersten Steckverbindungsabschnitt ausbildet und dass die Gleichspannungsteckverbindungseinrichtung eine zweite Klemmeinrichtung aufweist, die die zweite Federkontakteinrichtung gegen den zweiten Steckverbindungsabschnitt drückt, so dass sich ein elektrisch leitender Druckkontakt der zweiten Federkontakteinrichtung mit dem zweiten Steckverbindungsabschnitt ausbildet. In diesem Fall bildet das erste Steckverbindungselement zusammen mit dem zweiten Steckverbindungselement einen Stecker der Gleichspannungsteckverbindungseinrichtung aus und das dritte Steckverbindungselement bildet zusammen mit dem vierten Steckverbindungselement eine Buchse der Gleichspannungsteckverbindungseinrichtung aus. Durch die Klemmeinrichtungen wird das Stromrichtermodul darüber hinaus mit der Aufnahmeeinrichtung besonders zuverlässig elektrisch leitend verbunden.

In diesem Zusammenhang erweist es sich als vorteilhaft, wenn das erste Steckverbindungselement mit dem Aufnahmenegativpotentialelement und das zweite Steckverbindungselement mit dem Aufnahmepositivpotentialelement einstückig ausgebildet ist, und/oder dass das dritte Steckverbindungselement mit dem Modulnegativpotentialelement und das vierte Steckverbindungselement mit dem Modulpositivpotentialelement einstückig ausgebildet ist. Hierdurch ist die Gleichspannungsteckverbindungseinrichtung besonders zuverlässig ausgebildet.

Weiterhin erweist es sich als vorteilhaft, wenn das erste, zweite, dritte und vierte Steckverbindungselement als Flachleiter ausgebildet sind. Hierdurch ist die Gleichspannungsteckverbindungseinrichtung besonders niederinduktiv ausgebildet.

Ferner erweist es sich als vorteilhaft, wenn die Gleichspannungsteckverbindungseinrichtung im Steckverbindungsraum ein auf dem ersten Steckverbindungsabschnitt neben der ersten Federkontakteinrichtung angeordnetes erstes Abstandselement aufweist und ein auf dem zweiten Steckverbindungsabschnitt neben der zweiten Federkontakteinrichtung angeordnetes zweites Abstandselement aufweist, wobei das erste Abstandselement eine in Richtung auf den dritten Steckverbindungsabschnitt zu verlaufende derartige Dicke aufweist, dass, falls der dritte Steckverbindungsabschnitt einen mechanischen Kontakt mit dem ersten Abstandselement aufweist, das mindestens eine zweite Federelement immer noch einen elektrisch leitenden Druckkontakt mit dem vierten Steckverbindungsabschnitt aufweist, wobei das zweite Abstandselement eine in Richtung auf den vierten Steckverbindungsabschnitt zu verlaufende derartige Dicke aufweist, dass, falls der vierte Steckverbindungsabschnitt einen mechanischen Kontakt mit dem zweiten Abstandselement aufweist, das mindestens eine erste Federelement immer noch einen elektrisch leitenden Druckkontakt mit dem dritten Steckverbindungsabschnitt aufweist. Es ist somit sichergestellt, dass trotz Fertigungstoleranzen des Stromrichtermoduls und der Aufnahmeeinrichtung das Stromrichtermodul mit Aufnahmeeinrichtung über die Gleichspannungsteckverbindungseinrichtung zuverlässig elektrisch leitend verbunden ist.

In diesem Zusammenhang erweist es sich als vorteilhaft, wenn die Gleichspannungsteckverbindungseinrichtung im Steckverbindungsraum ein auf dem ersten Steckverbindungsabschnitt neben der ersten Federkontakteinrichtung angeordnetes drittes Abstandselement aufweist und ein auf dem zweiten Steckverbindungsabschnitt neben der zweiten Federkontakteinrichtung angeordnetes viertes Abstandselement aufweist, wobei die erste Federkontakteinrichtung zwischen dem ersten und dritten Abstandselement und die zweite Federkontakteinrichtung zwischen dem zweiten und vierten Abstandselement angeordnet ist, wobei das dritte Abstandselement eine in Richtung auf den dritten Steckverbindungsabschnitt zu verlaufende derartige Dicke aufweist, dass, falls der dritte Steckverbindungsabschnitt einen mechanischen Kontakt mit dem dritten Abstandselement aufweist, das mindestens eine zweite Federelement immer noch einen elektrisch leitenden Druckkontakt mit dem vierten Steckverbindungsabschnitt aufweist, wobei das vierte Abstandselement eine in Richtung auf den vierten Steckverbindungsabschnitt zu verlaufende derartige Dicke aufweist, dass, falls der vierte Steckverbindungsabschnitt einen mechanischen Kontakt mit dem vierten Abstandselement aufweist, das mindestens eine erste Federelement immer noch einen elektrisch leitenden Druckkontakt mit dem dritten Steckverbindungsabschnitt aufweist. Es ist somit sichergestellt, das trotz Fertigungstoleranzen des Stromrichtermoduls und der Aufnahmeeinrichtung das Stromrichtermodul mit Aufnahmeeinrichtung über die Gleichspannungsteckverbindungseinrichtung zuverlässig elektrisch leitend verbunden ist.

Ferner erweist es sich als vorteilhaft, wenn das erste Abstandselement und, falls vorhanden, das dritte Abstandselement sich an seinem bei einem Einführen des dritten und vierten Steckverbindungsabschnitts in den Steckverbindungsraum, dem dritten Steckverbindungsabschnitt zugewandten Endbereich verjüngt.

Ferner erweist es sich als vorteilhaft, wenn das zweite Abstandselement und, falls vorhanden, das vierte Abstandselement sich an seinem bei einem Einführen des dritten und vierten Steckverbindungsabschnitts in den Steckverbindungsraum, dem vierten Steckverbindungsabschnitt zugewandten Endbereich verjüngt.

Zum elektrisch leitenden Verbinden des Stromrichtermoduls mit der Aufnahmeeinrichtung werden das erste Steckverbindungselement zusammen mit dem zweiten Steckverbindungselement und das dritte Steckverbindungselement zusammen mit dem vierten Steckverbindungselement derart aufeinander zu bewegt, dass das dritte Steckverbindungselement zusammen mit dem vierten Steckverbindungselement in den Steckverbindungsraum eingeführt wird. Durch die sich verjüngenden Endbereiche der Abstandselemente wird das Einführen des dritten Steckverbindungselements zusammen mit dem vierten Steckverbindungselement in den Steckverbindungsraum erleichtert.

Weiterhin erweist es sich als vorteilhaft, wenn die erste Federkontakteinrichtung mehrere in einer Reihe angeordnete erste Federelemente aufweist und die zweite Federkontakteinrichtung mehrere in einer Reihe angeordnete zweite Federelemente aufweist. Hierdurch ist das Stromrichtermodul mit der Aufnahmeeinrichtung besonders zuverlässig elektrisch leitend verbunden.

Ferner erweist es sich als vorteilhaft, wenn das Stromrichtermodul ein Leistungshalbleitermodul, das miteinander elektrisch verschaltete Leistungshalbeiterschalter aufweist, und eine mit Gleichspannungsanschlüssen des Leistungshalbleitermoduls elektrisch leitend verbundene, mindestens einen Kondensator aufweisende Kondensatoreinrichtung aufweist, wobei die Kondensatoreinrichtung einen Zwischenkreiskondensator ausbildet.

Ein Ausführungsbeispiel der Erfindung wird nachfolgend unter Bezugnahme auf die unten stehenden Figuren erläutert. Dabei zeigen:
- FIG 1: eine perspektivische Ansicht einer erfindungsgemäßen Stromrichteranordnung bei der alle drei Stromrichtermodule mit einer Aufnahmeeinrichtung elektrisch leitend verbunden sind,
- FIG 2: eine perspektivische Ansicht einer erfindungsgemäßen Stromrichteranordnung bei der das links angeordnete Stromrichtermodul mit der Aufnahmeeinrichtung nicht elektrisch leitend verbunden ist,
- FIG 3: eine Seitenansicht von wesentlichen Teilen einer Gleichspannungsteckverbindungseinrichtung einer nicht beanspruchten Stromrichteranordnung und der die Gleichspannungsteckverbindungseinrichtung umgebenden Elemente der Stromrichteranordnung.
- FIG 4: eine Seitenansicht der erfindungsgemäßen Stromrichteranordnung, bei der das links angeordnete Stromrichtermodul mit der Aufnahmeeinrichtung nicht elektrisch leitend verbunden ist,
- FIG 5: eine Seitenansicht der Gleichspannungsteckverbindungseinrichtung der erfindungsgemäßen Stromrichteranordnung und der die Gleichspannungsteckverbindungseinrichtung umgebenden Elemente,
- FIG 6: eine perspektivische Detailansicht eines Teils der Gleichspannungsteckverbindungseinrichtung und
- FIG 7: eine perspektivische Ansicht eines Stromrichtermoduls der erfindungsgemäßen Stromrichteranordnung.

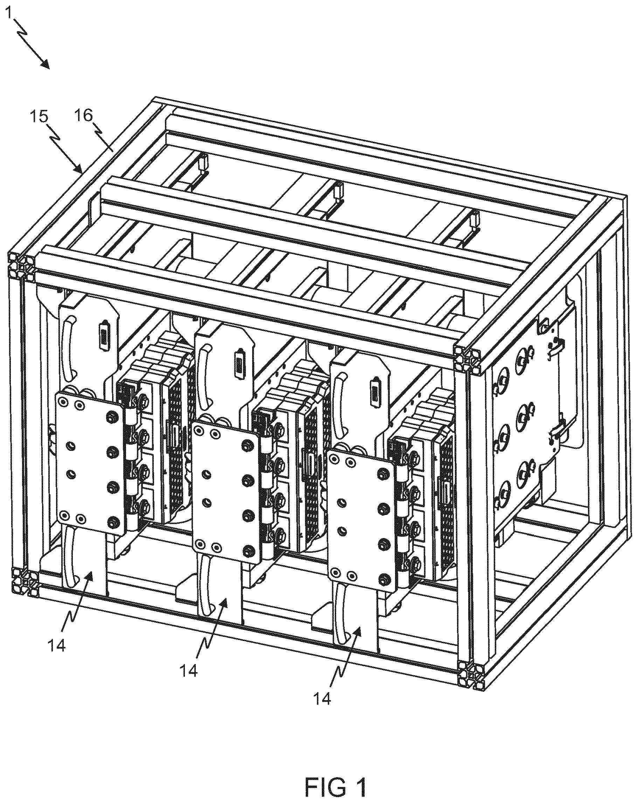

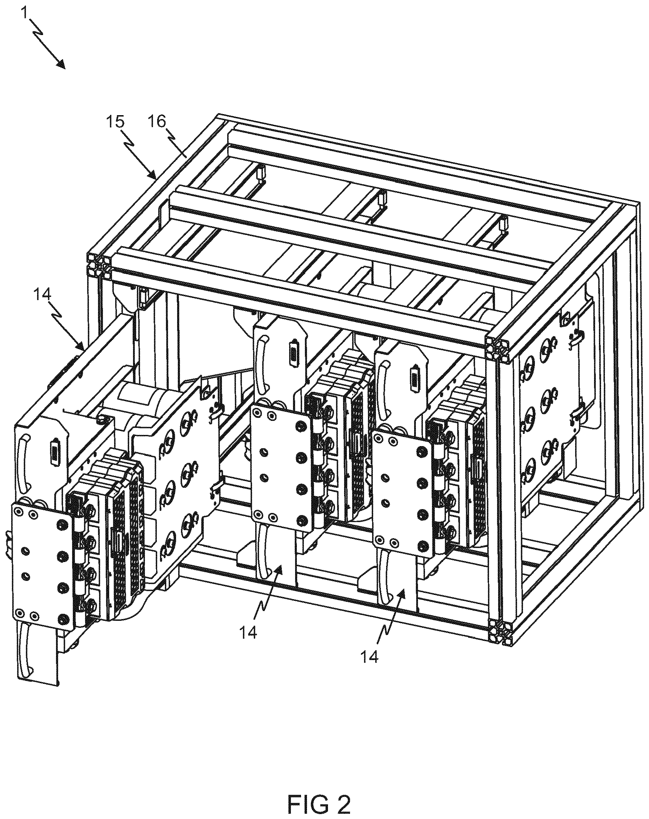

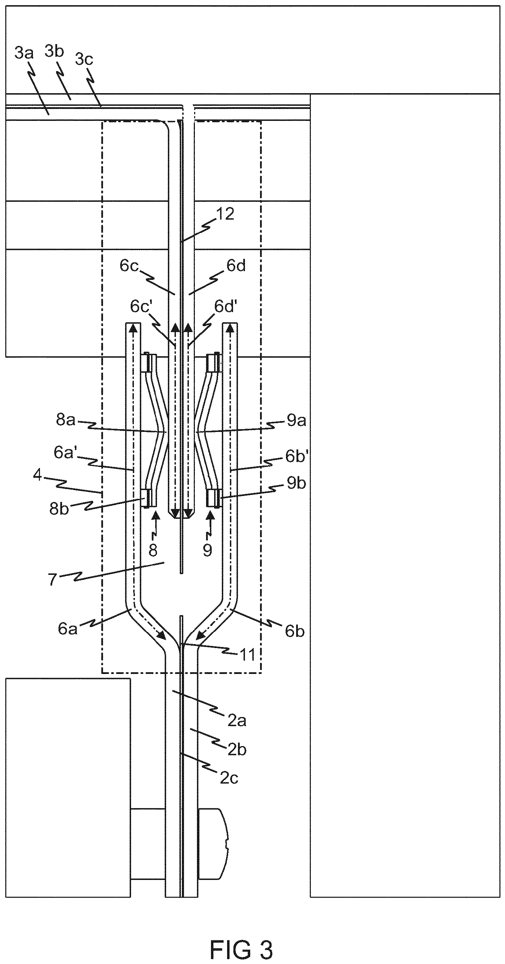

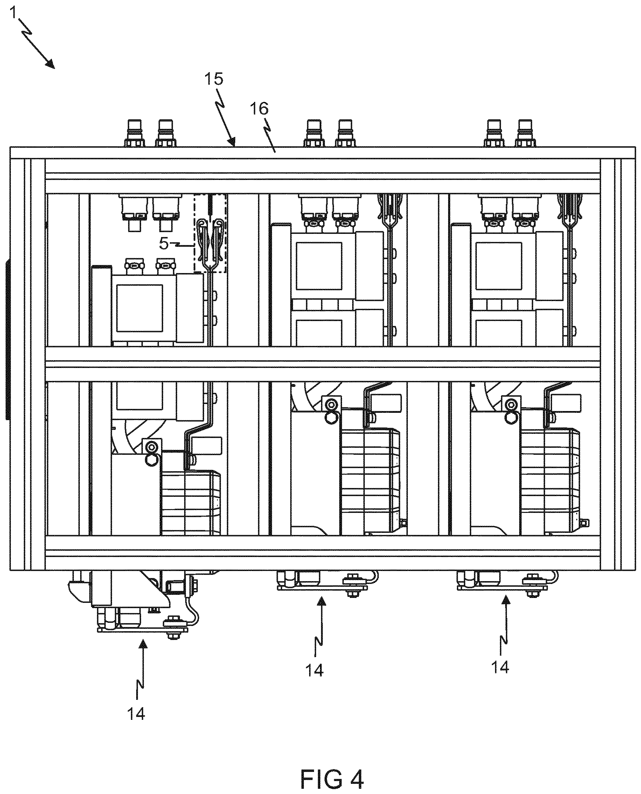

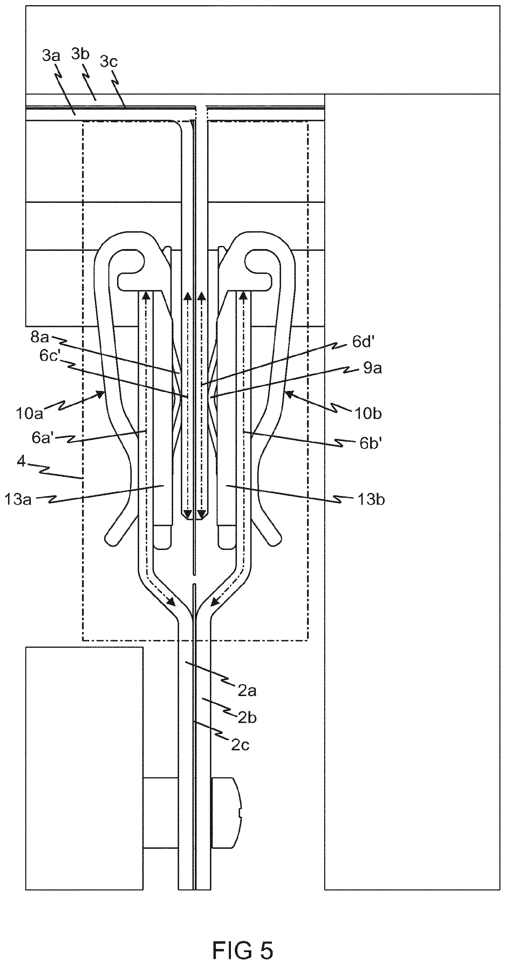

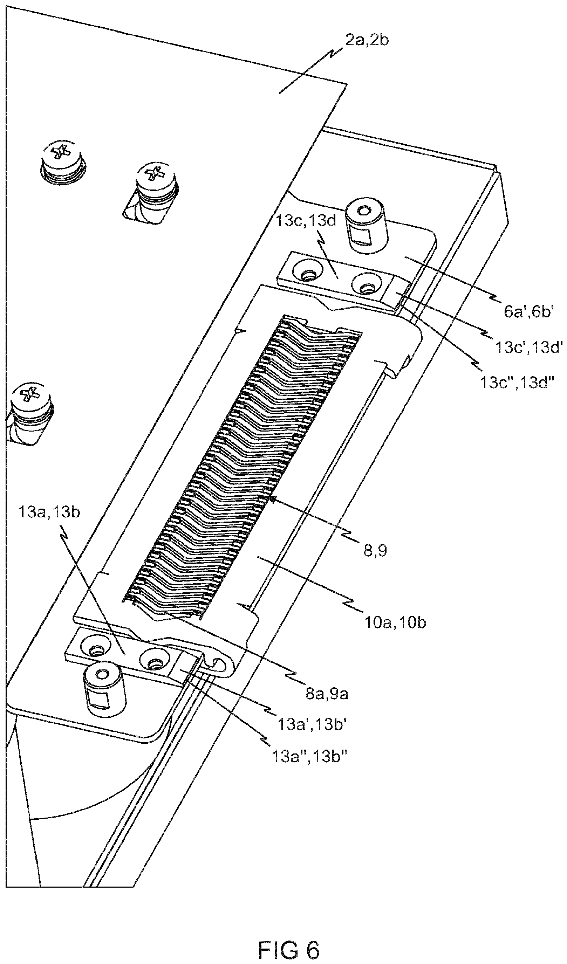

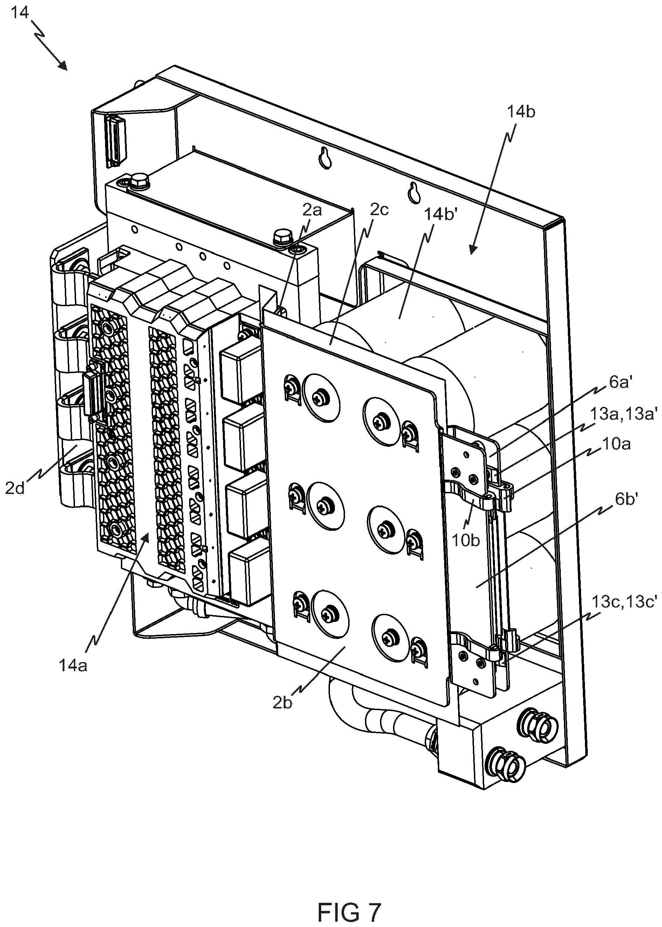

In FIG 1 ist eine perspektivische Ansicht einer erfindungsgemäßen Stromrichteranordnung 1, bei der alle drei Stromrichtermodule 14 mit einer Aufnahmeeinrichtung 15 elektrisch leitend verbunden sind, dargestellt. In FIG 2 ist das links angeordnete Stromrichtermodul 14 mit der Aufnahmeeinrichtung 15 nicht elektrisch leitend verbunden. In FIG 3 ist eine Seitenansicht einer Gleichspannungsteckverbindungseinrichtung 4 einer nicht beanspruchten Stromrichteranordnung 1 im Detail dargestellt, wobei ein Teil der Bauelemente der Gleichspannungsteckverbindungseinrichtung 4 nicht dargestellt ist. In FIG 4 ist eine Seitenansicht der Stromrichteranordnung 1, bei der das links angeordnete Stromrichtermodul 14 mit der Aufnahmeeinrichtung 15 nicht elektrisch leitend verbunden ist, dargestellt. In FIG 5 ist eine Seitenansicht der Gleichspannungsteckverbindungseinrichtung 4 im Detail dargestellt. In FIG 6 ist eine perspektivische Detailansicht eines Teils der Gleichspannungsteckverbindungseinrichtung 4 dargestellt. In FIG 7 ist eine perspektivische Ansicht des Stromrichtermoduls 14 dargestellt.

Die erfindungsgemäße Stromrichteranordnung 1 weist ein elektrisch leitendes Modulnegativpotentialelement 2a und ein elektrisch leitendes Modulpositivpotentialelement 2b aufweisendes Stromrichtermodul 14 auf. Zwischen dem Modulnegativpotentialelement 2a und dem Modulpositivpotentialelement 2b ist vorzugweise eine elektrisch nicht leitende Isolationsschicht 2c, die z.B. als Kunststofffolie ausgebildet sein kann, angeordnet. Das Modulnegativpotentialelement 2a und das Modulpositivpotentialelement 2b sind vorzugsweise als Flachleiter, insbesondere als Blechelemente, ausgebildet. Das Modulnegativpotentialelement 2a und das Modulpositivpotentialelement 2b bilden zusammen mit der Isolationsschicht 2c eine Modulgleichspannungsverschienung aus. Wie beispielhaft in FIG 7 dargestellt, weist das Stromrichtermodul 14 vorzugsweise ein Leistungshalbleitermodul 14a, das miteinander elektrisch verschaltete Leistungshalbeiterschalter aufweist und eine mit Gleichspannungsanschlüssen des Leistungshalbleitermoduls 14a elektrisch leitend verbundene, mindestens einen Kondensator 14b' aufweisende Kondensatoreinrichtung 14b auf, wobei die Kondensatoreinrichtung 14b einen Zwischenkreiskondensator ausbildet. Das Modulnegativpotentialelement 2a, das Modulpositivpotentialelement 2b sind mit der Kondensatoreinrichtung 14b elektrisch leitend verbunden. Die Leistungshalbeiterschalter sind vorzugsweise elektrisch zu mindestens einer Halbbrückenschaltung verschalten. Das Stromrichtermodul 14 weist weiterhin ein Modulwechselpotentialelement 2d auf. Das Modulnegativpotentialelement 2a, das Modulpositivpotentialelement 2b und das Modulwechselpotentialelement 2d sind mit den Leistungshalbeiterschaltern elektrisch leitend verbunden. Zwischen dem Modulnegativpotentialelement 2a und dem Modulpositivpotentialelement 2b liegt im Betrieb der Stromrichteranordnung 1 eine Gleichspannung an.

Die Stromrichteranordnung 1 weist weiterhin ein elektrisch leitendes Aufnahmenegativpotentialelement 3a und ein elektrisch leitendes Aufnahmepositivpotentialelement 3b aufweisende Aufnahmeeinrichtung 15 zur Aufnahme des Stromrichtermoduls 14 auf. Die Aufnahmeeinrichtung 15 weist vorzugsweise, wie beispielhaft in den Figuren 1 bis 3 dargestellt, ein Rahmenelement 16 auf. Das Rahmenelement 16 kann z.B. in einem Schaltschrank montiert sein. Zwischen dem Aufnahmenegativpotentialelement 3a und dem Aufnahmepositivpotentialelement 3b ist vorzugweise eine elektrisch nicht leitende Isolationsschicht 3c, die z.B. als Kunststofffolie ausgebildet sein kann, angeordnet. Das Aufnahmenegativpotentialelement 3a und das Aufnahmepositivpotentialelement 3b sind vorzugsweise als Flachleiter, insbesondere als Blechelemente, ausgebildet. Das Aufnahmenegativpotentialelement 3a und das Aufnahmepositivpotentialelement 3b bilden zusammen mit der Isolationsschicht 2c eine Aufnahmegleichspannungsverschienung aus.

Im Betrieb der Stromrichteranordnung 1 weisen das Modulnegativpotentialelement 2a und das Aufnahmenegativpotentialelement 3a ein negatives elektrisches Potential auf und das Modulpositivpotentialelement 2b und das Aufnahmepositivpotentialelement 3b ein positives elektrisches Potential auf. Zwischen dem Aufnahmenegativpotentialelement 3a und dem Aufnahmepositivpotentialelement 3b liegt im Betrieb der Stromrichteranordnung 1 eine Gleichspannung an.

Das Modulnegativpotentialelement 2a ist mit dem Aufnahmenegativpotentialelement 3a und das Modulpositivpotentialelement 2b ist mit dem Aufnahmepositivpotentialelement 3b über eine Gleichspannungsteckverbindungseinrichtung 4 elektrisch leitend verbunden. Bei der Erfindung ist somit das Stromrichtermodul 14 mit der Aufnahmeeinrichtung 15 über die Gleichspannungsteckverbindungseinrichtung 4 elektrisch leitend verbunden. Hierdurch kann das Stromrichtermodul 14 mit der Aufnahmeeinrichtung 15 schnell und zuverlässig elektrisch leitend verbunden und wieder getrennt werden.

Im Rahmen des Ausführungsbeispiels weist die Stromrichteranordnung 1 drei Stromrichtermodule 14 auf, die mit der Aufnahmeeinrichtung 15 über eine jeweilige Gleichspannungsteckverbindungseinrichtung 4 elektrisch leitend verbunden sind. Selbstverständlich kann die erfindungsgemäße Stromrichteranordnung 1 auch nur ein einzelnes Stromrichtermodul 14 aufweisen, das mit der Aufnahmeeinrichtung 15 über eine Gleichspannungsteckverbindungseinrichtung 4 elektrisch leitend verbunden ist oder noch erheblich mehr Stromrichtermodule 14 aufweisen, die mit der Aufnahmeeinrichtung 15 über eine jeweilige Gleichspannungsteckverbindungseinrichtung 4 elektrisch leitend verbunden sind.

Die Gleichspannungsteckverbindungseinrichtung 4 weist vorzugsweise, wie beispielhaft in FIG 3 und FIG 5 im Detail dargestellt, ein elektrisch leitendes erstes Steckverbindungselement 6a, ein vom ersten Steckverbindungselement 6a elektrisch isoliert angeordnetes elektrisch leitendes zweites Steckverbindungselement 6b, ein elektrisch leitendes drittes Steckverbindungselement 6c und ein vom dritten Steckverbindungselement 6c elektrisch isoliertes angeordnetes elektrisch leitendes viertes Steckverbindungselement 6d auf. Das erste Steckverbindungselement 6a ist mit dem Modulnegativpotentialelement 2a, das zweite Steckverbindungselement 6b ist mit dem Modulpositivpotentialelement 2b, das dritte Steckverbindungselement 6c ist mit dem Aufnahmenegativpotentialelement 3a und das vierte Steckverbindungselement 6d ist mit dem Aufnahmepositivpotentialelement 3b elektrisch leitend kontaktiert. Die jeweilige Kontaktierung kann z.B. mittels einer stoffschlüssigen Verbindung, insbesondere mittels einer Löt- oder Schweißverbindung, realisiert sein. Die jeweilige Kontaktierung ist vorzugsweise realisiert, indem das erste Steckverbindungselement 6a mit dem Modulnegativpotentialelement 2a und das zweite Steckverbindungselement 6b mit dem Modulpositivpotentialelement 2b einstückig ausgebildet ist, und/oder indem das dritte Steckverbindungselement 6c mit dem Aufnahmenegativpotentialelement 3a und das vierte Steckverbindungselement 6d mit dem Aufnahmepositivpotentialelement 3b einstückig ausgebildet ist. Beim Ausführungsbeispiel ist das erste Steckverbindungselement 6a mit dem Modulnegativpotentialelement 2a und das zweite Steckverbindungselement 6b ist mit dem Modulpositivpotentialelement 2b einstückig ausgebildet, und das dritte Steckverbindungselement 6c ist mit dem Aufnahmenegativpotentialelement 3a und das vierte Steckverbindungselement 6d ist mit dem Aufnahmepositivpotentialelement 3b einstückig ausgebildet. Zwischen dem ersten Steckverbindungselement 6a und dem zweiten Steckverbindungselement 6b ist vorzugsweise in einem Abschnitt eine elektrisch nicht leitende Isolationsschicht 11, die z.B. als Kunststofffolie ausgebildet sein kann, angeordnet. Die Isolationsschicht 11 ist vorzugsweise mit der Isolationsschicht 2c einstückig ausgebildet. Zwischen dem dritten Steckverbindungselement 6c und dem vierten Steckverbindungselement 6d ist vorzugsweise eine elektrisch nicht leitende Isolationsschicht 12, die z.B. als Kunststofffolie ausgebildet sein kann, angeordnet. Die Isolationsschicht 12 ist vorzugsweise mit der Isolationsschicht 3c einstückig ausgebildet.

Das erste Steckverbindungselement 6a weist einen ersten Steckverbindungsabschnitt 6a' und das zweite Steckverbindungselement 6b einen vom ersten Steckverbindungsabschnitt 6a' beabstandet angeordneten zweiten Steckverbindungsabschnitt 6b' auf, wobei zwischen dem ersten und zweiten Steckverbindungsabschnitt 6a' und 6b' ein Steckverbindungsraum 7 ausgebildet ist. Das dritte Steckverbindungselement 6c weist einen dritten Steckverbindungsabschnitt 6c' und das vierte Steckverbindungselement 6d einen vierten Steckverbindungsabschnitt 6d' auf, wobei der dritte und vierte Steckverbindungsabschnitt 6c' und 6d` im Steckverbindungsraum 7 angeordnet sind.

Die Gleichspannungsteckverbindungseinrichtung 4 weist weiterhin eine mit dem ersten Steckverbindungsabschnitt 6a' einen elektrisch leitenden Kontakt aufweisende elektrisch leitende erste Federkontakteinrichtung 8 auf, die mindestens ein erstes Federelement 8a aufweist, das gegen den dritten Steckverbindungsabschnitt 6c' drückt und hierdurch einen elektrisch leitenden Druckkontakt mit dem dritten Steckverbindungsabschnitt 6c' ausbildet. Die erste Federkontakteinrichtung 8 weist weiterhin vorzugsweise mindestens ein elektrisch leitendes erstes Federhalteelement 8b auf, das das mindestens eine erste Federelement 8a hält und mit dem mindestens einen ersten Federelement 8a elektrisch leitend kontaktiert ist. Das mindestens eine erste Federhalteelement 8b ist mit dem ersten Steckverbindungsabschnitt 6a' elektrisch leitend kontaktiert, insbesondere elektrisch leitend druckkontaktiert. Die Gleichspannungsteckverbindungseinrichtung 4 weist weiterhin eine mit dem zweiten Steckverbindungsabschnitt 6b' einen elektrisch leitenden Kontakt aufweisende elektrisch leitende zweite Federkontakteinrichtung 9 auf, die mindestens ein zweites Federelement 9a aufweist, das gegen den vierten Steckverbindungsabschnitt 6d' drückt und hierdurch einen elektrisch leitenden Druckkontakt mit dem vierten Steckverbindungsabschnitt 6d' ausbildet. Die zweite Federkontakteinrichtung 9 weist weiterhin vorzugsweise mindestens ein elektrisch leitendes zweites Federhalteelement 9b auf, das das mindestens eine zweite Federelement 9a hält und mit dem mindestens einen zweiten Federelement 9a elektrisch leitend kontaktiert ist. Das mindestens eine zweite Federhalteelement 9b ist mit dem zweiten Steckverbindungsabschnitt 6b' elektrisch leitend kontaktiert, insbesondere elektrisch leitend druckkontaktiert.

Bei oben beschriebener Gleichspannungsteckverbindungseinrichtung 4 bildet das erste Steckverbindungselement 6a zusammen mit dem zweiten Steckverbindungselement 6b eine Buchse der Gleichspannungsteckverbindungseinrichtung 4 aus und das dritte Steckverbindungselement 6c bildet zusammen mit dem vierten Steckverbindungselement 6d einen Stecker der Gleichspannungsteckverbindungseinrichtung 4 aus.

Alternativ kann, wie nachfolgend beschrieben, das erste Steckverbindungselement 6a zusammen mit dem zweiten Steckverbindungselement 6b einen Stecker der Gleichspannungsteckverbindungseinrichtung 4 ausbilden und das dritte Steckverbindungselement 6c zusammen mit dem vierten Steckverbindungselement 6d eine Buchse der Gleichspannungsteckverbindungseinrichtung 4 ausbilden. Bei dieser Ausbildung der Gleichspannungsteckverbindungseinrichtung 4, die in den Figuren nicht dargestellt ist, ist das erste Steckverbindungselement 6a mit dem Aufnahmenegativpotentialelement 3a, das zweite Steckverbindungselement 6b mit dem Aufnahmepositivpotentialelement 3b, das dritte Steckverbindungselement 6c mit dem Modulnegativpotentialelement 2a und das vierte Steckverbindungselement 6d mit dem Modulpositivpotentialelement 2b elektrisch leitend kontaktiert. Die jeweilige Kontaktierung kann z.B. mittels einer stoffschlüssigen Verbindung, insbesondere mittels einer Löt- oder Schweißverbindung, realisiert sein. Das erste Steckverbindungselement 6a ist vorzugsweise mit dem Aufnahmenegativpotentialelement 3a und das zweite Steckverbindungselement 6b mit dem Aufnahmepositivpotentialelement 3b einstückig ausgebildet, und/oder das dritte Steckverbindungselement 6c ist vorzugsweise mit dem Modulnegativpotentialelement 2a und das vierte Steckverbindungselement 6d ist mit dem Modulpositivpotentialelement 2b einstückig ausgebildet. Ansonsten entspricht diese Ausbildung der Gleichspannungsteckverbindungseinrichtung 4 der oben beschriebenen Gleichspannungsteckverbindungseinrichtung 4 bei der das erste Steckverbindungselement 6a zusammen mit dem zweiten Steckverbindungselement 6b die Buchse der Gleichspannungsteckverbindungseinrichtung 4 und das dritte Steckverbindungselement 6c zusammen mit dem vierten Steckverbindungselement 6d den Stecker der Gleichspannungsteckverbindungseinrichtung 4 ausbildet.

Die nachfolgende Beschreibung bezieht sich jeweils auf beide oben beschriebenen Ausbildungen der Gleichspannungsteckverbindungseinrichtung 4.

Zum elektrisch leitenden Verbinden des Stromrichtermoduls 14 mit der Aufnahmeeinrichtung 15 werden das erste Steckverbindungselement 6a zusammen mit dem zweiten Steckverbindungselement 6b und das dritte Steckverbindungselement 6c zusammen mit dem vierten Steckverbindungselement 6d derart aufeinander zu bewegt, dass das dritte Steckverbindungselement 6c zusammen mit dem vierten Steckverbindungselement 6d in den Steckverbindungsraum 7 eingeführt wird, so dass das mindestens eine erste Federelement 8a gegen den dritten Steckverbindungsabschnitt 6c' drückt und hierdurch einen elektrisch leitenden Druckkontakt mit dem dritten Steckverbindungsabschnitt 6c' ausbildet und das mindestens eine zweite Federelement 9a gegen den vierten Steckverbindungsabschnitt 6d' drückt und hierdurch einen elektrisch leitenden Druckkontakt mit dem vierten Steckverbindungsabschnitt 6d' ausbildet. Zum elektrischen Trennen des Stromrichtermoduls 14 von der Aufnahmeeinrichtung 15 werden das erste Steckverbindungselement 6a zusammen mit dem zweiten Steckverbindungselement 6b und das dritte Steckverbindungselement 6c zusammen mit dem vierten Steckverbindungselement 6d derart voneinander weg bewegt, dass das dritte Steckverbindungselement 6c zusammen mit dem vierten Steckverbindungselement 6d aus den Steckverbindungsraum 7 herausgeführt wird.

Das erste, zweite, dritte und vierte Steckverbindungselement 6a, 6b, 6c und 6d sind vorzugsweise als Flachleiter, insbesondere als Blechelemente, ausgebildet. Das erste, zweite, dritte und vierte Steckverbindungselement 6a, 6b, 6c und 6d sind vorzugsweise zumindest im Wesentlichen aus Kupfer oder aus einer Kupferlegierung ausgebildet.

Die erste Federkontakteinrichtung 8 weist vorzugsweise mehrere in einer Reihe angeordnete erste Federelemente 8a und die zweite Federkontakteinrichtung 9 mehrere in einer Reihe angeordnete zweite Federelemente 9a auf.

Die Gleichspannungsteckverbindungseinrichtung 4 weist vorzugsweise eine erste Klemmeinrichtung 10a auf, die die erste Federkontakteinrichtung 8, genauer ausgedrückt hier das mindestens eine erste Federhalteelement 8b, gegen den ersten Steckverbindungsabschnitt 6a' drückt, so dass sich ein elektrisch leitender Druckkontakt der ersten Federkontakteinrichtung 8 mit dem ersten Steckverbindungsabschnitt 6a' ausbildet, und eine zweite Klemmeinrichtung 10b auf, die die zweite Federkontakteinrichtung 9, genauer ausgedrückt hier das mindestens eine zweite Federhalteelement 9b, gegen den zweiten Steckverbindungsabschnitt 6b' drückt, so dass sich ein elektrisch leitender Druckkontakt der zweiten Federkontakteinrichtung 9 mit dem zweiten Steckverbindungsabschnitt 6b' ausbildet.

Die Gleichspannungsteckverbindungseinrichtung 4 weist weiterhin, wie beispielhaft in FIG 5, FIG 6 und FIG 7 dargestellt, im Steckverbindungsraum 7 vorzugsweise ein auf dem ersten Steckverbindungsabschnitt 6a' neben der ersten Federkontakteinrichtung 8 angeordnetes erstes Abstandselement 13a und ein auf dem zweiten Steckverbindungsabschnitt 6b' neben der zweiten Federkontakteinrichtung 9 angeordnetes zweites Abstandselement 13b auf. Das erste Abstandselement 13a weist eine in Richtung auf den dritten Steckverbindungsabschnitt 6c' zu verlaufende derartige Dicke auf, dass, falls der dritte Steckverbindungsabschnitt 6c' einen mechanischen Kontakt mit dem ersten Abstandselement 13a aufweist, das mindestens eine zweite Federelement 9a immer noch einen elektrisch leitenden Druckkontakt mit dem vierten Steckverbindungsabschnitt 6d' aufweist. Das zweite Abstandselement 13b weist eine in Richtung auf den vierten Steckverbindungsabschnitt 6d' zu verlaufende derartige Dicke auf, dass, falls der vierte Steckverbindungsabschnitt 6d` einen mechanischen Kontakt mit dem zweiten Abstandselement 13b aufweist, das mindestens eine erste Federelement 8a immer noch einen elektrisch leitenden Druckkontakt mit dem dritten Steckverbindungsabschnitt 6c' aufweist.

Die Gleichspannungsteckverbindungseinrichtung 4 weist weiterhin, wie beispielhaft in FIG 6 und FIG 7 dargestellt, im Steckverbindungsraum 7 vorzugsweise ein auf dem ersten Steckverbindungsabschnitt 6a' neben der ersten Federkontakteinrichtung 8 angeordnetes drittes Abstandselement 13c und ein auf dem zweiten Steckverbindungsabschnitt 6b' neben der zweiten Federkontakteinrichtung 9 angeordnetes viertes Abstandselement 13d auf. Die erste Federkontakteinrichtung 8 ist zwischen dem ersten und dritten Abstandselement 13a und 13c und die zweite Federkontakteinrichtung 9 ist zwischen dem zweiten und vierten Abstandselement 13b und 13d angeordnet. Das dritte Abstandselement 13c weist eine in Richtung auf den dritten Steckverbindungsabschnitt 6c' zu verlaufende derartige Dicke auf, dass, falls der dritte Steckverbindungsabschnitt 6c' einen mechanischen Kontakt mit dem dritten Abstandselement 13c aufweist, das mindestens eine zweite Federelement 9a immer noch einen elektrisch leitenden Druckkontakt mit dem vierten Steckverbindungsabschnitt 6d' aufweist. Das vierte Abstandselement 13d weist eine in Richtung auf den vierten Steckverbindungsabschnitt 6d' zu verlaufende derartige Dicke auf, dass, falls der vierte Steckverbindungsabschnitt 6d` einen mechanischen Kontakt mit dem vierten Abstandselement 13d aufweist, das mindestens eine erste Federelement 8a immer noch einen elektrisch leitenden Druckkontakt mit dem dritten Steckverbindungsabschnitt 6c' aufweist.

Die jeweiligen Abstandselemente 13a, 13b, 13c bzw.13d stellen sicher, dass, falls der dritte und vierte Steckverbindungsabschnitt 6c' und 6d' nicht im Steckverbindungsraum 7 mittig angeordnet sind, sondern bezogen auf FIG 5 links oder rechts aus der Mitte des Steckverbindungsraums 7 versetzt im Steckverbindungsraum 7 angeordnet sind, der jeweilig mögliche Versatz derartig begrenzt bleibt, dass das mindestens eine erste Federelement 8a immer noch zuverlässig gegen den dritten Steckverbindungsabschnitt 6c' drückt und das mindestens eine zweite Federelement 9a immer noch zuverlässig gegen den vierten Steckverbindungsabschnitt 6d' drückt. Es ist somit sichergestellt, das trotz Fertigungstoleranzen des Stromrichtermoduls 14 und der Aufnahmeeinrichtung 15, das Stromrichtermodul 14 mit Aufnahmeeinrichtung 15 über die Gleichspannungsteckverbindungseinrichtung 4 zuverlässig elektrisch leitend verbunden sind.

Das erste Abstandselement 13a und, falls vorhanden, das dritte Abstandselement 13c verjüngt sich vorzugsweise, wie beispielhaft in FIG 6 dargestellt, an seinem bei einem Einführen des dritten und vierten Steckverbindungsabschnitts 6c' und 6d' in den Steckverbindungsraum 7, dem dritten Steckverbindungsabschnitt 6c' zugewandten Endbereich 13a' bzw. 13c`. Das erste Abstandselement 13a und, falls vorhanden, das dritte Abstandselement 13c verjüngt sich in Richtung auf das jeweilige Ende 13a" bzw. 13c" des jeweiligen Endbereichs 13a' bzw. 13c' zu.

Das zweite Abstandselement 13b und, falls vorhanden, das vierte Abstandselement 13d verjüngt sich vorzugsweise, wie beispielhaft in FIG 6 dargestellt, an seinem bei einem Einführen des dritten und vierten Steckverbindungsabschnitts 6c' und 6d' in den Steckverbindungsraum 7, dem vierten Steckverbindungsabschnitt 6d` zugewandten Endbereich 13b' bzw. 13d`. Das zweite Abstandselement 13b und, falls vorhanden, das vierte Abstandselement 13d verjüngt sich in Richtung auf das jeweilige Ende 13b" bzw. 13d" des jeweiligen Endbereichs 13b' bzw. 13d' zu.

## Patentansprüche

1. Stromrichteranordnung mit einem ein elektrisch leitendes Modulnegativpotentialelement (2a) und ein elektrisch leitendes Modulpositivpotentialelement (2b) aufweisenden Stromrichtermodul (14), mit einer ein elektrisch leitendes Aufnahmenegativpotentialelement (3a) und ein elektrisch leitendes Aufnahmepositivpotentialelement (3b) aufweisenden Aufnahmeeinrichtung (15) zur Aufnahme des Stromrichtermoduls (14), wobei das Modulnegativpotentialelement (2a) mit dem Aufnahmenegativpotentialelement (3a) und das Modulpositivpotentialelement (2b) mit dem Aufnahmepositivpotentialelement (3b) über eine Gleichspannungsteckverbindungseinrichtung (4) elektrisch leitend verbunden sind, wobei die Gleichspannungsteckverbindungseinrichtung (4) ein elektrisch leitendes erstes Steckverbindungselement (6a), ein vom ersten Steckverbindungselement (6a) elektrisch isoliert angeordnetes elektrisch leitendes zweites Steckverbindungselement (6b), ein elektrisch leitendes drittes Steckverbindungselement (6c) und ein vom dritten Steckverbindungselement (6c) elektrisch isoliertes angeordnetes elektrisch leitendes viertes Steckverbindungselement (6d) aufweist, wobei das erste Steckverbindungselement (6a) mit dem Modulnegativpotentialelement (2a), das zweite Steckverbindungselement (6b) mit dem Modulpositivpotentialelement (2b), das dritte Steckverbindungselement (6c) mit dem Aufnahmenegativpotentialelement (3a) und das vierte Steckverbindungselement (6d) mit dem Aufnahmepositivpotentialelement (3b) elektrisch leitend kontaktiert ist, wobei das erste Steckverbindungselement (6a) einen ersten Steckverbindungsabschnitt (6a') und das zweite Steckverbindungselement (6b) einen vom ersten Steckverbindungsabschnitt (6a') beabstandet angeordneten zweiten Steckverbindungsabschnitt (6b') aufweist, wobei zwischen dem ersten und zweiten Steckverbindungsabschnitt (6a`,6b`) ein Steckverbindungsraum (7) ausgebildet ist, wobei das dritte Steckverbindungselement (6c) einen dritten Steckverbindungsabschnitt (6c`) und das vierte Steckverbindungselement (6d) einen vierten Steckverbindungsabschnitt (6d') aufweist, wobei der dritte und vierte Steckverbindungsabschnitt (6c`,6d`) im Steckverbindungsraum (7) angeordnet sind, **dadurch gekennzeichnet, dass** die Gleichspannungsteckverbindungseinrichtung (4) eine mit dem ersten Steckverbindungsabschnitt (6a') einen elektrisch leitenden Kontakt aufweisende elektrisch leitende erste Federkontakteinrichtung (8) aufweist, die mindestens ein erstes Federelement (8a) aufweist, das gegen den dritten Steckverbindungsabschnitt (6c`) drückt und hierdurch einen elektrisch leitenden Druckkontakt mit dem dritten Steckverbindungsabschnitt (6c`) ausbildet, wobei die Gleichspannungsteckverbindungseinrichtung (4) eine mit dem zweiten Steckverbindungsabschnitt (6b') einen elektrisch leitenden Kontakt aufweisende elektrisch leitende zweite Federkontakteinrichtung (9) aufweist, die mindestens ein zweites Federelement (9a) aufweist, das gegen den vierten Steckverbindungsabschnitt (6d') drückt und hierdurch einen elektrisch leitenden Druckkontakt mit dem vierten Steckverbindungsabschnitt (6d') ausbildet, wobei die Gleichspannungsteckverbindungseinrichtung (4) eine erste Klemmeinrichtung (10a) aufweist, die die erste Federkontakteinrichtung (8) gegen den ersten Steckverbindungsabschnitt (6a') drückt, so dass sich ein elektrisch leitender Druckkontakt der ersten Federkontakteinrichtung (8) mit dem ersten Steckverbindungsabschnitt (6a`) ausbildet und dass die Gleichspannungsteckverbindungseinrichtung (4) eine zweite Klemmeinrichtung (10b) aufweist, die die zweite Federkontakteinrichtung (9) gegen den zweiten Steckverbindungsabschnitt (6b') drückt, so dass sich ein elektrisch leitender Druckkontakt der zweiten Federkontakteinrichtung (9) mit dem zweiten Steckverbindungsabschnitt (6b') ausbildet.

2. Stromrichteranordnung nach Anspruch 2, **dadurch gekennzeichnet, dass** das erste Steckverbindungselement (6a) mit dem Modulnegativpotentialelement (2a) und das zweite Steckverbindungselement (6b) mit dem Modulpositivpotentialelement (2b) einstückig ausgebildet ist, und/oder dass das dritte Steckverbindungselement (6c) mit dem Aufnahmenegativpotentialelement (3a) und das vierte Steckverbindungselement (6d) mit dem Aufnahmepositivpotentialelement (3b) einstückig ausgebildet ist.

3. Stromrichteranordnung mit einem ein elektrisch leitendes Modulnegativpotentialelement (2a) und ein elektrisch leitendes Modulpositivpotentialelement (2b) aufweisenden Stromrichtermodul (14), mit einer ein elektrisch leitendes Aufnahmenegativpotentialelement (3a) und ein elektrisch leitendes Aufnahmepositivpotentialelement (3b) aufweisenden Aufnahmeeinrichtung (15) zur Aufnahme des Stromrichtermoduls (14), wobei das Modulnegativpotentialelement (2a) mit dem Aufnahmenegativpotentialelement (3a) und das Modulpositivpotentialelement (2b) mit dem Aufnahmepositivpotentialelement (3b) über eine Gleichspannungsteckverbindungseinrichtung (4) elektrisch leitend verbunden sind wobei die Gleichspannungsteckverbindungseinrichtung (4) ein elektrisch leitendes erstes Steckverbindungselement (6a), ein vom ersten Steckverbindungselement (6a) elektrisch isoliert angeordnetes elektrisch leitendes zweites Steckverbindungselement (6b), ein elektrisch leitendes drittes Steckverbindungselement (6c) und ein vom dritten Steckverbindungselement (6c) elektrisch isoliertes angeordnetes elektrisch leitendes viertes Steckverbindungselement (6d) aufweist, wobei das erste Steckverbindungselement (6a) mit dem Aufnahmenegativpotentialelement (3a), das zweite Steckverbindungselement (6b) mit dem Aufnahmepositivpotentialelement (3b), das dritte Steckverbindungselement (6c) mit dem Modulnegativpotentialelement (2a) und das vierte Steckverbindungselement (6d) mit dem Modulpositivpotentialelement (2b) elektrisch leitend kontaktiert ist, wobei das erste Steckverbindungselement (6a) einen ersten Steckverbindungsabschnitt (6a') und das zweite Steckverbindungselement (6b) einen vom ersten Steckverbindungsabschnitt (6a') beabstandet angeordneten zweiten Steckverbindungsabschnitt (6b') aufweist, wobei zwischen dem ersten und zweiten Steckverbindungsabschnitt (6a`,6b`) ein Steckverbindungsraum (7) ausgebildet ist, wobei das dritte Steckverbindungselement (6c) einen dritten Steckverbindungsabschnitt (6c`) und das vierte Steckverbindungselement (6d) einen vierten Steckverbindungsabschnitt (6d') aufweist, wobei der dritte und vierte Steckverbindungsabschnitt (6c`,6d`) im Steckverbindungsraum (7) angeordnet sind, **dadurch gekennzeichnet, dass** die Gleichspannungsteckverbindungseinrichtung (4) eine mit dem ersten Steckverbindungsabschnitt (6a') einen elektrisch leitenden Kontakt aufweisende elektrisch leitende erste Federkontakteinrichtung (8) aufweist, die mindestens ein erstes Federelement (8a) aufweist, das gegen den dritten Steckverbindungsabschnitt (6c`) drückt und hierdurch einen elektrisch leitenden Druckkontakt mit dem dritten Steckverbindungsabschnitt (6c`) ausbildet, wobei die Gleichspannungsteckverbindungseinrichtung (4) eine mit dem zweiten Steckverbindungsabschnitt (6b') einen elektrisch leitenden Kontakt aufweisende elektrisch leitende zweite Federkontakteinrichtung (9) aufweist, die mindestens ein zweites Federelement (9a) aufweist, das gegen den vierten Steckverbindungsabschnitt (6d') drückt und hierdurch einen elektrisch leitenden Druckkontakt mit dem vierten Steckverbindungsabschnitt (6d') ausbildet, wobei die Gleichspannungsteckverbindungseinrichtung (4) eine erste Klemmeinrichtung (10a) aufweist, die die erste Federkontakteinrichtung (8) gegen den ersten Steckverbindungsabschnitt (6a') drückt, so dass sich ein elektrisch leitender Druckkontakt der ersten Federkontakteinrichtung (8) mit dem ersten Steckverbindungsabschnitt (6a') ausbildet und dass die Gleichspannungsteckverbindungseinrichtung (4) eine zweite Klemmeinrichtung (10b) aufweist, die die zweite Federkontakteinrichtung (9) gegen den zweiten Steckverbindungsabschnitt (6b') drückt, so dass sich ein elektrisch leitender Druckkontakt der zweiten Federkontakteinrichtung (9) mit dem zweiten Steckverbindungsabschnitt (6b') ausbildet.

4. Stromrichteranordnung nach Anspruch 3, **dadurch gekennzeichnet, dass** das erste Steckverbindungselement (6a) mit dem Aufnahmenegativpotentialelement (3a) und das zweite Steckverbindungselement (6b) mit dem Aufnahmepositivpotentialelement (3b) einstückig ausgebildet ist, und/oder dass das dritte Steckverbindungselement (6c) mit dem Modulnegativpotentialelement (2a) und das vierte Steckverbindungselement (6d) mit dem Modulpositivpotentialelement (2b) einstückig ausgebildet ist.

5. Stromrichteranordnung nach einem der Ansprüche 2 bis 4, **dadurch gekennzeichnet, dass** das erste, zweite, dritte und vierte Steckverbindungselement (6a,6b,6c,6d) als Flachleiter ausgebildet sind.

6. Stromrichteranordnung nach einem der Ansprüche 2 bis 5, **dadurch gekennzeichnet, dass** die Gleichspannungsteckverbindungseinrichtung (4) im Steckverbindungsraum (7) ein auf dem ersten Steckverbindungsabschnitt (6a') neben der ersten Federkontakteinrichtung (8) angeordnetes erstes Abstandselement (13a) aufweist und ein auf dem zweiten Steckverbindungsabschnitt (6b') neben der zweiten Federkontakteinrichtung (9) angeordnetes zweites Abstandselement (13b) aufweist, wobei das erste Abstandselement (13a) eine in Richtung auf den dritten Steckverbindungsabschnitt (6c`) zu verlaufende derartige Dicke aufweist, dass, falls der dritte Steckverbindungsabschnitt (6c`) einen mechanischen Kontakt mit dem ersten Abstandselement (13a) aufweist, das mindestens eine zweite Federelement (9a) immer noch einen elektrisch leitenden Druckkontakt mit dem vierten Steckverbindungsabschnitt (6d') aufweist, wobei das zweite Abstandselement (13b) eine in Richtung auf den vierten Steckverbindungsabschnitt (6d') zu verlaufende derartige Dicke aufweist, dass, falls der vierte Steckverbindungsabschnitt (6d') einen mechanischen Kontakt mit dem zweiten Abstandselement (13b) aufweist, das mindestens eine erste Federelement (8a) immer noch einen elektrisch leitenden Druckkontakt mit dem dritten Steckverbindungsabschnitt (6c`) aufweist.

7. Stromrichteranordnung nach Anspruch 6, **dadurch gekennzeichnet, dass** die Gleichspannungsteckverbindungseinrichtung (4) im Steckverbindungsraum (7) ein auf dem ersten Steckverbindungsabschnitt (6a') neben der ersten Federkontakteinrichtung (8) angeordnetes drittes Abstandselement (13c) aufweist und ein auf dem zweiten Steckverbindungsabschnitt (6b') neben der zweiten Federkontakteinrichtung (9) angeordnetes viertes Abstandselement (13d) aufweist, wobei die erste Federkontakteinrichtung (8) zwischen dem ersten und dritten Abstandselement (13a, 13c) und die zweite Federkontakteinrichtung (9) zwischen dem zweiten und vierten Abstandselement (13b, 13d) angeordnet ist, wobei das dritte Abstandselement (13c) eine in Richtung auf den dritten Steckverbindungsabschnitt (6c`) zu verlaufende derartige Dicke aufweist, dass, falls der dritte Steckverbindungsabschnitt (6c`) einen mechanischen Kontakt mit dem dritten Abstandselement (13c) aufweist, das mindestens eine zweite Federelement (9a) immer noch einen elektrisch leitenden Druckkontakt mit dem vierten Steckverbindungsabschnitt (6d') aufweist, wobei das vierte Abstandselement (13d) eine in Richtung auf den vierten Steckverbindungsabschnitt (6d') zu verlaufende derartige Dicke aufweist, dass, falls der vierte Steckverbindungsabschnitt (6d') einen mechanischen Kontakt mit dem vierten Abstandselement (13d) aufweist, das mindestens eine erste Federelement (8a) immer noch einen elektrisch leitenden Druckkontakt mit dem dritten Steckverbindungsabschnitt (6c`) aufweist.

8. Stromrichteranordnung nach Anspruch 6 oder 7, **dadurch gekennzeichnet, dass** das erste Abstandselement (13a) und, falls vorhanden, das dritte Abstandselement (13c) sich an seinem bei einem Einführen des dritten und vierten Steckverbindungsabschnitts (6c',6d') in den Steckverbindungsraum (7), dem dritten Steckverbindungsabschnitt (6c`) zugewandten Endbereich (13a`,13c`) verjüngt.

9. Stromrichteranordnung nach einem der Ansprüche 6 bis 8, **dadurch gekennzeichnet, dass** das zweite Abstandselement (13b) und, falls vorhanden, das vierte Abstandselement (13d) sich an seinem bei einem Einführen des dritten und vierten Steckverbindungsabschnitts (6c',6d') in den Steckverbindungsraum (7), dem vierten Steckverbindungsabschnitt (6d') zugewandten Endbereich (13b',13d') verjüngt.

10. Stromrichteranordnung nach einem der Ansprüche 2 bis 9, **dadurch gekennzeichnet, dass** die erste Federkontakteinrichtung (8) mehrere in einer Reihe angeordnete erste Federelemente (8a) aufweist und die zweite Federkontakteinrichtung (9) mehrere in einer Reihe angeordnete zweite Federelemente (9a) aufweist.

11. Stromrichteranordnung nach einem der vorhergehenden Ansprüche, **dadurch gekennzeichnet, dass** das Stromrichtermodul (14) ein Leistungshalbleitermodul (14a), das miteinander elektrisch verschaltete Leistungshalbeiterschalter aufweist, und eine mit Gleichspannungsanschlüssen des Leistungshalbleitermoduls (14a) elektrisch leitend verbundene, mindestens einen Kondensator (14b') aufweisende Kondensatoreinrichtung (14b) aufweist, wobei die Kondensatoreinrichtung (14b) einen Zwischenkreiskondensator ausbildet.

## Claims

1. Power converter arrangement comprising a power converter module (14) having an electrically conductive module negative potential element (2a) and an electrically conductive module positive potential element (2b), comprising a receiver device (15) for receiving the power converter module (14), said receiver device having an electrically conductive receiver negative potential element (3a) and an electrically conductive receiver positive potential element (3b), wherein a DC voltage plug connection device (4) electrically conductively connects the module negative potential element (2a) to the receiver negative potential element (3a) and the module positive potential element (2b) to the receiver positive potential element (3b), wherein the DC voltage plug connection device (4) has an electrically conductive first plug connection element (6a), an electrically conductive second plug connection element (6b) arranged such that it is electrically isolated from the first plug connection element (6a), an electrically conductive third plug connection element (6c) and an electrically conductive fourth plug connection element (6d) arranged such that it is electrically isolated from the third plug connection element (6c), wherein the first plug connection element (6a) is in electrically conductive contact with the module negative potential element (2a), the second plug connection element (6b) is in electrically conductive contact with the module positive potential element (2b), the third plug connection element (6c) is in electrically conductive contact with the receiver negative potential element (3a) and the fourth plug connection element (6d) is in electrically conductive contact with the receiver positive potential element (3b), wherein the first plug connection element (6a) has a first plug connection section (6a') and the second plug connection element (6b) has a second plug connection section (6b') arranged spaced apart from the first plug connection section (6a'), wherein a plug connection space (7) is formed between the first and second plug connection sections (6a', 6b'), wherein the third plug connection element (6c) has a third plug connection section (6c') and the fourth plug connection element (6d) has a fourth plug connection section (6d'), wherein the third and fourth plug connection sections (6c', 6d') are arranged in the plug connection space (7), **characterized in that** the DC voltage plug connection device (4) has an electrically conductive first spring contact device (8) having electrically conductive contact with the first plug connection section (6a') and having at least one first spring element (8a) which presses against the third plug connection section (6c') and thereby forms electrically conductive pressure contact with the third plug connection section (6c'), wherein the DC voltage plug connection device (4) has an electrically conductive second spring contact device (9) having electrically conductive contact with the second plug connection section (6b') and having at least one second spring element (9a) which presses against the fourth plug connection section (6d') and thereby forms electrically conductive pressure contact with the fourth plug connection section (6d'), wherein the DC voltage plug connection device (4) has a first clamping device (10a) which presses the first spring contact device (8) against the first plug connection section (6a') such that electrically conductive pressure contact between the first spring contact device (8) and the first plug connection section (6a') is formed and **in that** the DC voltage plug connection device (4) has a second clamping device (10b) which presses the second spring contact device (9) against the second plug connection section (6b') such that electrically conductive pressure contact between the second spring contact device (9) and the second plug connection section (6b') is formed.

2. Power converter arrangement according to Claim 2, **characterized in that** the first plug connection element (6a) is formed in one piece with the module negative potential element (2a) and the second plug connection element (6b) is formed in one piece with the module positive potential element (2b), and/or **in that** the third plug connection element (6c) is formed in one piece with the receiver negative potential element (3a) and the fourth plug connection element (6d) is formed in one piece with the receiver positive potential element (3b).

3. Power converter arrangement comprising a power converter module (14) having an electrically conductive module negative potential element (2a) and an electrically conductive module positive potential element (2b), comprising a receiver device (15) for receiving the power converter module (14), said receiver device having an electrically conductive receiver negative potential element (3a) and an electrically conductive receiver positive potential element (3b), wherein a DC voltage plug connection device (4) electrically conductively connects the module negative potential element (2a) to the receiver negative potential element (3a) and the module positive potential element (2b) to the receiver positive potential element (3b), wherein the DC voltage plug connection device (4) has an electrically conductive first plug connection element (6a), an electrically conductive second plug connection element (6b) arranged such that it is electrically isolated from the first plug connection element (6a), an electrically conductive third plug connection element (6c) and an electrically conductive fourth plug connection element (6d) arranged such that it is electrically isolated from the third plug connection element (6c), wherein the first plug connection element (6a) is in electrically conductive contact with the receiver negative potential element (3a), the second plug connection element (6b) is in electrically conductive contact with the receiver positive potential element (3b), the third plug connection element (6c) is in electrically conductive contact with the module negative potential element (2a) and the fourth plug connection element (6d) is in electrically conductive contact with the module positive potential element (2b), wherein the first plug connection element (6a) has a first plug connection section (6a') and the second plug connection element (6b) has a second plug connection section (6b') arranged spaced apart from the first plug connection section (6a'), wherein a plug connection space (7) is formed between the first and second plug connection sections (6a', 6b'), wherein the third plug connection element (6c) has a third plug connection section (6c') and the fourth plug connection element (6d) has a fourth plug connection section (6d'), wherein the third and fourth plug connection sections (6c', 6d') are arranged in the plug connection space (7), **characterized in that** the DC voltage plug connection device (4) has an electrically conductive first spring contact device (8) having electrically conductive contact with the first plug connection section (6a') and having at least one first spring element (8a) which presses against the third plug connection section (6c') and thereby forms electrically conductive pressure contact with the third plug connection section (6c'), wherein the DC voltage plug connection device (4) has an electrically conductive second spring contact device (9) having electrically conductive contact with the second plug connection section (6b') and having at least one second spring element (9a) which presses against the fourth plug connection section (6d') and thereby forms electrically conductive pressure contact with the fourth plug connection section (6d'), wherein the DC voltage plug connection device (4) has a first clamping device (10a) which presses the first spring contact device (8) against the first plug connection section (6a') such that electrically conductive pressure contact between the first spring contact device (8) and the first plug connection section (6a') is formed and **in that** the DC voltage plug connection device (4) has a second clamping device (10b) which presses the second spring contact device (9) against the second plug connection section (6b') such that electrically conductive pressure contact between the second spring contact device (9) and the second plug connection section (6b') is formed.

4. Power converter arrangement according to Claim 3, **characterized in that** the first plug connection element (6a) is formed in one piece with the receiver negative potential element (3a) and the second plug connection element (6b) is formed in one piece with the receiver positive potential element (3b), and/or **in that** the third plug connection element (6c) is formed in one piece with the module negative potential element (2a) and the fourth plug connection element (6d) is formed in one piece with the module positive potential element (2b).

5. Power converter arrangement according to one of Claims 2 to 4, **characterized in that** the first, second, third and fourth plug connection elements (6a, 6b, 6c, 6d) are in the form of flat conductors.

6. Power converter arrangement according to one of Claims 2 to 5, **characterized in that** the DC voltage plug connection device (4), in the plug connection space (7), has a first spacer element (13a) arranged on the first plug connection section (6a') next to the first spring contact device (8) and has a second spacer element (13b) arranged on the second plug connection section (6b') next to the second spring contact device (9), wherein the first spacer element (13a) has such a thickness extending in the direction of the third plug connection section (6c') that if the third plug connection section (6c') has mechanical contact with the first spacer element (13a) the at least one second spring element (9a) still has electrically conductive pressure contact with the fourth plug connection section (6d'), wherein the second spacer element (13b) has such a thickness extending in the direction of the fourth plug connection section (6d') that if the fourth plug connection section (6d') has mechanical contact with the second spacer element (13b) the at least one first spring element (8a) still has electrically conductive pressure contact with the third plug connection section (6c').

7. Power converter arrangement according to Claim 6, **characterized in that** the DC voltage plug connection device (4), in the plug connection space (7), has a third spacer element (13c) arranged on the first plug connection section (6a') next to the first spring contact device (8) and has a fourth spacer element (13d) arranged on the second plug connection section (6b') next to the second spring contact device (9), wherein the first spring contact device (8) is arranged between the first and third spacer elements (13a, 13c) and the second spring contact device (9) is arranged between the second and fourth spacer elements (13b, 13d), wherein the third spacer element (13c) has such a thickness extending in the direction of the third plug connection section (6c') that if the third plug connection section (6c') has mechanical contact with the third spacer element (13c) the at least one second spring element (9a) still has electrically conductive pressure contact with the fourth plug connection section (6d'), wherein the fourth spacer element (13d) has such a thickness extending in the direction of the fourth plug connection section (6d') that if the fourth plug connection section (6d') has mechanical contact with the fourth spacer element (13d) the at least one first spring element (8a) still has electrically conductive pressure contact with the third plug connection section (6c').

8. Power converter arrangement according to Claim 6 or 7, **characterized in that** the first spacer element (13a) and, if present, the third spacer element (13c) tapers at its end region (13a', 13c') facing the third plug connection section (6c') when the third and fourth plug connection sections (6c', 6d') are inserted into the plug connection space (7).

9. Power converter arrangement according to one of Claims 6 to 8, **characterized in that** the second spacer element (13b) and, if present, the fourth spacer element (13d) tapers at its end region (13b', 13d') facing the fourth plug connection section (6d') when the third and fourth plug connection sections (6c', 6d') are inserted into the plug connection space (7).

10. Power converter arrangement according to one of Claims 2 to 9, **characterized in that** the first spring contact device (8) has a plurality of first spring elements (8a) arranged in a row and the second spring contact device (9) has a plurality of second spring elements (9a) arranged in a row.

11. Power converter arrangement according to one of the preceding claims, **characterized in that** the power converter module (14) has a power semiconductor module (14a) which has power semiconductor switches electrically connected to one another, and a capacitor device (14b) electrically conductively connected to DC voltage terminals of the power semiconductor module (14a) and having at least one capacitor (14b'), wherein the capacitor device (14b) forms a DC link capacitor.

## Revendications

1. Agencement de convertisseur de courant pourvu d'un module de convertisseur de courant (14) présentant un élément de potentiel négatif de module électriquement conducteur (2a) et un élément de potentiel positif de module électriquement conducteur (2b), comprenant un dispositif de réception (15) présentant un élément de potentiel négatif de réception électriquement conducteur (3a) et un élément de potentiel positif de réception électriquement conducteur (3b) pour recevoir le module de convertisseur de courant (14), dans lequel l'élément de potentiel négatif de module (2a) est relié de manière électriquement conductrice à l'élément de potentiel négatif de réception (3a), et l'élément de potentiel positif de module (2b) est relié à l'élément de potentiel positif de réception (3b) par l'intermédiaire d'un dispositif de connexion enfichable à tension continue (4), dans lequel le dispositif de connexion enfichable à tension continue (4) présente un premier élément de connexion enfichable électriquement conducteur (6a), un deuxième élément de connexion enfichable électriquement conducteur (6b) disposé de manière électriquement isolée par rapport au premier élément de connexion enfichable (6a), un troisième élément de connexion enfichable électriquement conducteur (6c) et un quatrième élément de connexion enfichable électriquement conducteur (6d) isolé électriquement par rapport au troisième élément de connexion enfichable (6c), dans lequel le premier élément de connexion enfichable (6a) est en contact électriquement conducteur avec l'élément de potentiel négatif de module (2a), le deuxième élément de connexion enfichable (6b) avec l'élément de potentiel positif de module (2b), le troisième élément de connexion enfichable (6c) avec l'élément de potentiel négatif de réception (3a) et le quatrième élément de connexion enfichable (6d) avec l'élément de potentiel positif de réception (3b), dans lequel le premier élément de connexion enfichable (6a) présente une première partie de connexion enfichable (6a') et le deuxième élément de connexion enfichable (6b) présente une deuxième partie de connexion enfichable (6b') disposée à distance de la première partie de connexion enfichable (6a'), dans lequel un espace de connexion enfichable (7) est réalisé entre la première et la deuxième partie de connexion enfichable (6a', 6b'), dans lequel le troisième élément de connexion enfichable (6c) présente une troisième partie de connexion enfichable (6c') et le quatrième élément de connexion enfichable (6d) présente une quatrième partie de connexion enfichable (6d'), dans lequel la troisième et la quatrième partie de connexion enfichable (6c', 6d') sont disposées dans l'espace de connexion enfichable (7),
**caractérisé en ce que** le dispositif de connexion enfichable à tension continue (4) présente un premier dispositif de contact à ressort électriquement conducteur (8) présentant un contact électriquement conducteur avec la première partie de connexion enfichable (6a') et présentant au moins un premier élément faisant ressort (8a) qui appuie sur la troisième partie de connexion enfichable (6c') et réalise ainsi un contact par pression électriquement conducteur avec la troisième partie de connexion enfichable (6c'), dans lequel le dispositif de connexion enfichable à tension continue (4) présente un deuxième dispositif de contact à ressort (9) présentant un contact électriquement conducteur avec la deuxième partie de connexion enfichable (6b') et présentant au moins un deuxième élément faisant ressort (9a) qui appuie sur la quatrième partie de connexion enfichable (6d') et réalise ainsi un contact par pression électriquement conducteur avec la quatrième partie de connexion enfichable (6d'), dans lequel le dispositif de connexion enfichable à tension continue (4) présente un premier dispositif de serrage (10a) qui pousse le premier dispositif de contact à ressort (8) contre la première partie de connexion enfichable (6a') de sorte qu'un contact par pression électriquement conducteur du premier dispositif de contact à ressort (8) avec la première partie de connexion enfichable (6a') soit réalisé, et **en ce que** le dispositif de connexion enfichable à tension continue (4) présente un deuxième dispositif de serrage (10b) qui pousse le deuxième dispositif de contact à ressort (9) contre la deuxième partie de connexion enfichable (6b') de telle sorte qu'un contact par pression électriquement conducteur du deuxième dispositif de contact à ressort (9) avec la deuxième partie de connexion enfichable (6b') soit réalisé.

2. Agencement de convertisseur de courant selon la revendication 2, **caractérisé en ce que** le premier élément de connexion enfichable (6a) est réalisé d'un seul tenant avec l'élément de potentiel négatif de module (2a) et le deuxième élément de connexion enfichable (6b) est réalisé d'un seul tenant avec l'élément de potentiel positif de module (2b), et/ou **en ce que** le troisième élément de connexion enfichable (6c) est réalisé d'un seul tenant avec l'élément de potentiel négatif de réception (3a) et le quatrième élément de connexion enfichable (6d) est réalisé d'un seul tenant avec l'élément de potentiel positif de réception (3b).

3. Agencement de convertisseur de courant pourvu d'un module de convertisseur de courant (14) présentant un élément de potentiel négatif de module électriquement conducteur (2a) et un élément de potentiel positif de module électriquement conducteur (2b), comprenant un dispositif de réception (15) présentant un élément de potentiel négatif de réception électriquement conducteur (3a) et un élément de potentiel positif de réception électriquement conducteur (3b) pour recevoir le module de convertisseur de courant (14), dans lequel l'élément de potentiel négatif de module (2a) est relié de manière électriquement conductrice à l'élément de potentiel négatif de réception (3a), et l'élément de potentiel positif de module (2b) est relié à l'élément de potentiel positif de réception (3b) par l'intermédiaire d'un dispositif de connexion enfichable à tension continue (4), dans lequel le dispositif de connexion enfichable à tension continue (4) présente un premier élément de connexion enfichable électriquement conducteur (6a), un deuxième élément de connexion enfichable électriquement conducteur (6b) disposé de manière électriquement isolée par rapport au premier élément de connexion enfichable (6a), un troisième élément de connexion enfichable électriquement conducteur (6c) et un quatrième élément de connexion enfichable électriquement conducteur (6d) isolé électriquement par rapport au troisième élément de connexion enfichable (6c), dans lequel le premier élément de connexion enfichable (6a) est en contact électriquement conducteur avec l'élément de potentiel négatif de réception (3a), le deuxième élément de connexion enfichable (6b) avec l'élément de potentiel positif de réception (3b), le troisième élément de connexion enfichable (6c) avec l'élément de potentiel négatif de module (2a) et le quatrième élément de connexion enfichable (6d) avec l'élément de potentiel positif de module (2b), dans lequel le premier élément de connexion enfichable (6a) présente une première partie de connexion enfichable (6a') et le deuxième élément de connexion enfichable (6b) présente une deuxième partie de connexion enfichable (6b') disposée à distance de la première partie de connexion enfichable (6a'), dans lequel un espace de connexion enfichable (7) est réalisé entre la première et la deuxième partie de connexion enfichable (6a', 6b'), dans lequel le troisième élément de connexion enfichable (6c) présente une troisième partie de connexion enfichable (6c') et le quatrième élément de connexion enfichable (6d) présente une quatrième partie de connexion enfichable (6d'), dans lequel la troisième et la quatrième partie de connexion enfichable (6c', 6d') sont disposées dans l'espace de connexion enfichable (7),
**caractérisé en ce que** le dispositif de connexion enfichable à tension continue (4) présente un premier dispositif de contact à ressort électriquement conducteur (8) présentant un contact électriquement conducteur avec la première partie de connexion enfichable (6a') et présentant au moins un premier élément faisant ressort (8a) qui appuie sur la troisième partie de connexion enfichable (6c') et réalise ainsi un contact par pression électriquement conducteur avec la troisième partie de connexion enfichable (6c'), dans lequel le dispositif de connexion enfichable à tension continue (4) présente un deuxième dispositif de contact à ressort (9) présentant un contact électriquement conducteur avec la deuxième partie de connexion enfichable (6b') et présentant au moins un deuxième élément faisant ressort (9a) qui appuie sur la quatrième partie de connexion enfichable (6d') et réalise ainsi un contact par pression électriquement conducteur avec la quatrième partie de connexion enfichable (6d'), dans lequel le dispositif de connexion enfichable à tension continue (4) présente un premier dispositif de serrage (10a) qui pousse le premier dispositif de contact à ressort (8) contre la première partie de connexion enfichable (6a') de telle sorte qu'un contact par pression électriquement conducteur du premier dispositif de contact à ressort (8) avec la première partie de connexion enfichable (6a') soit réalisé, et **en ce que** le dispositif de connexion enfichable à tension continue (4) présente un deuxième dispositif de serrage (10b) qui pousse le deuxième dispositif de contact à ressort (9) contre la deuxième partie de connexion enfichable (6b') de telle sorte qu'un contact par pression électriquement conducteur du deuxième dispositif de contact à ressort (9) avec la deuxième partie de connexion enfichable (6b') soit réalisé.

4. Agencement de convertisseur de courant selon la revendication 3, **caractérisé en ce que** le premier élément de connexion enfichable (6a) est réalisé d'un seul tenant avec l'élément de potentiel négatif de réception (3a) et le deuxième élément de connexion enfichable (6b) est réalisé d'un seul tenant avec l'élément de potentiel positif de réception (3b), et/ou **en ce que** le troisième élément de connexion enfichable (6c) est réalisé d'un seul tenant avec l'élément de potentiel négatif de module (2a) et le quatrième élément de connexion enfichable (6d) est réalisé d'un seul tenant avec l'élément de potentiel positif de module (2b)s.

5. Agencement de convertisseur de courant selon l'une quelconque des revendications 2 à 4, **caractérisé en ce que** le premier, le deuxième, le troisième et le quatrième élément de connexion enfichable (6a, 6b, 6c, 6d) sont réalisés sous forme de conducteurs plats.

6. Agencement de convertisseur de courant selon l'une quelconque des revendications 2 à 5, **caractérisé en ce que** le dispositif de connexion enfichable à tension continue (4) présente dans l'espace de connexion enfichable (7) un premier élément d'écartement (13a) disposé sur la première partie de connexion enfichable (6a') à côté du premier dispositif de contact à ressort (8) et présente un deuxième élément d'écartement (13b) disposé sur la deuxième partie de connexion enfichable (6b') à côté du deuxième dispositif de contact à ressort (9), dans lequel le premier élément d'écartement (13a) présente une épaisseur s'étendant en direction de la troisième partie de connexion enfichable (6c') de telle sorte que si la troisième partie de connexion enfichable (6c') présente un contact mécanique avec le premier élément d'écartement (13a), ledit au moins un deuxième élément faisant ressort (9a) présente toujours un contact par pression électriquement conducteur avec la quatrième partie de connexion enfichable (6d'), dans lequel le deuxième élément d'écartement (13b) présente une épaisseur s'étendant en direction de la quatrième partie de connexion enfichable (6d') de telle sorte que si la quatrième partie de connexion enfichable (6d') présente un contact mécanique avec le deuxième élément d'écartement (13b), ledit au moins un premier élément faisant ressort (8a) présente toujours un contact par pression électriquement conducteur avec la troisième partie de connexion enfichable (6c').

7. Agencement de convertisseur de courant selon la revendication 6, **caractérisé en ce que** le dispositif de connexion enfichable à tension continue (4) présente dans l'espace de connexion enfichable (7) un troisième élément d'écartement (13c) disposé sur la première partie de connexion enfichable (6a') à côté du premier dispositif de contact à ressort (8), et un quatrième élément d'écartement (13d) disposé sur la deuxième partie de connexion enfichable (6b') à côté du deuxième dispositif de contact à ressort (9), dans lequel le premier dispositif de contact à ressort (8) est disposé entre le premier et le troisième élément d'écartement (13a, 13c) et le deuxième dispositif de contact à ressort (9) est disposé entre le deuxième et le quatrième élément d'écartement (13b, 13d), dans lequel le troisième élément d'écartement (13c) présente une épaisseur s'étendant en direction de la troisième partie de connexion enfichable (6c') de telle sorte que si la troisième partie de connexion enfichable (6c') présente un contact mécanique avec le troisième élément d'écartement (13c), ledit au moins un deuxième élément faisant ressort (9a) présente toujours un contact par pression électriquement conducteur avec la quatrième partie de connexion enfichable (6d'), dans lequel le quatrième élément d'écartement (13d) présente une épaisseur s'étendant en direction de la quatrième partie de connexion enfichable (6d') de telle sorte que si la quatrième partie de connexion enfichable (6d') présente un contact mécanique avec le quatrième élément d'écartement (13d), ledit au moins un premier élément faisant ressort (8a) présente toujours un contact par pression électriquement conducteur avec la troisième partie de connexion enfichable (6c').

8. Agencement de convertisseur de courant selon la revendication 6 ou 7, **caractérisé en ce que** le premier élément d'écartement (13a) et, le cas échéant, le troisième élément d'écartement (13c) s'amincissent au niveau d'une zone d'extrémité (13a', 13c') tournée vers la troisième partie de connexion enfichable (6c') lors de l'introduction de la troisième et de la quatrième partie de connexion enfichable (6c', 6d') dans l'espace de connexion enfichable (7).

9. Agencement de convertisseur de courant selon l'une quelconque des revendications 6 à 8, **caractérisé en ce que** le deuxième élément d'écartement (13b) et, le cas échéant, le quatrième élément d'écartement (13d) s'amincissent au niveau d'une zone d'extrémité (13b', 13d') tournée vers la quatrième partie de connexion enfichable (6d') lors de l'introduction de la troisième et de la quatrième partie de connexion enfichable (6c', 6d') dans l'espace enfichable (7).

10. Agencement de convertisseur de courant selon l'une quelconque des revendications 2 à 9, **caractérisé en ce que** le premier dispositif de contact à ressort (8) présente plusieurs premiers éléments faisant ressort (8a) disposés en série, et le deuxième dispositif de contact à ressort (9) présente plusieurs deuxièmes éléments faisant ressort (9a) disposés en série.

11. Agencement de convertisseur de courant selon l'une quelconque des revendications précédentes, **caractérisé en ce que** le module de convertisseur de courant (14) présente un module semi-conducteur de puissance (14a) qui présente des commutateurs semi-conducteurs de puissance câblés électriquement les uns avec les autres, et présente un dispositif de condensateur (14b) relié de manière électriquement conductrice à des bornes de tension continue du module semi-conducteur de puissance (14a) et présentant au moins un condensateur (14b'), dans lequel le dispositif de condensateur (14b) réalise un condensateur de circuit intermédiaire.
